(19) Europäisches Patentamt
European Patent Office
Office européen des brevets

(11) Publication number: 0 023 758 B1

(12) EUROPEAN PATENT SPECIFICATION

(45) Date of publication of patent specification: 08.12.82

(51) Int. Cl.³: G 03 C 5/24, G 03 F 7/08

(21) Application number: 80302059.3

(22) Date of filing: 18.06.80

# (54) Stabilised developer concentrates and developers containing a quaternary alkanol ammonium hydroxide.

(30) Priority: 18.06.79 US 49765

(43) Date of publication of application: 11.02.81 Bulletin 81/6

(45) Publication of the grant of the patent: 08.12.82 Bulletin 82/49

(84) Designated Contracting States: DE FR GB IT

(56) References cited: US - A - 4 141 733

(73) Proprietor: EASTMAN KODAK COMPANY
343 State Street
Rochester, New York 14650 (US)

(72) Inventor: Guild, John R.
Kodak Park
Rochester New York (US)

(74) Representative: Pepper, John Herbert et al,
KODAK LIMITED Patent Department P.O. Box 114
190 High Holborn
London WC1V 7EA (GB)

EP 0 023 758 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

# Stabilised developer concentrates and developers containing a quaternary alkanol ammonium hydroxide

This invention relates to the stabilization of developer concentrates containing quaternary alkanol ammonium hydroxides. Developers formed from such concentrates are useful for developing presensitised lithographic plates containing a light-sensitive quinone diazide layer.

An important class of light-sensitive materials that is widely utilized in the graphic arts in the formation of photomechanical images is the class of quinone diazides.

Light-sensitive quinone diazides are well known materials which have been extensively described in the patent literature, for example, in United States Patents 2,754,209; 3,046,110; 3,046,112; 3,046,113; 3,046,116; 3,046,118; 3,046,119; 3,046,120; 3,647,443 and 3,759,711. The monomeric quinone diazide can be incorporated in an alkali-soluble resinous binder or reacted with an alkali-soluble resinous material so that it can be used satisfactorily as a resist material or can withstand the wear on printing plates.

These materials enjoy extensive use in such important applications as positive-working photoresist films and positive-working lithographic printing plates. Exposure of the composition to actinic radiation results in a solubility differential between the exposed and unexposed areas such that treatment with an appropriate developer results in removal of the radiation struck areas and retention of the desired image areas on the support. It is believed that such exposure decomposes the diazo structure in the radiation struck areas to form the free carboxylic acid group, thereby rendering the exposed areas soluble in alkaline developer solutions. The developer solutions which are employed for this purpose can be aqueous solutions or organic solutions.

It is known that quaternary ammonium hydroxide developing agents can be used in developer compositions that are employed in developing light-sensitive quinone diazide layers. Especially useful quaternary ammonium hydroxide developing agents are the quaternary alkanol ammonium hydroxides such as, for example, the methyltriethanolammonium hydroxide of United States patent 4,141,733. As described in that patent, this developing agent is particularly advantageous for use in forming a metal-ion-free developer composition that is especially adapted for forming fine image detail in the utilization of photoresists in the manufacture of integrated circuit devices. Developer compositions containing methyltriethanolammonium hydroxide provide many highly advantageous characteristics such as extended development latitude, increased exposure latitude, improved resist contrast, improved prebake latitude, a low depletion rate and minimal loss of image layer thickness.

While developer compositions containing quaternary alkanol ammonium hydroxide developing agents are excellent developers for resists of the quinone diazide type, the concentrates suffer from a serious problem in that gradual decomposition of the quaternary alkanol ammonium hydroxide compound, with consequent darkening of the concentrate and changes in the performance of the developer, tends to take place. It is toward the objective of providing a developer concentrate that is stable, so that its performance does not change significantly with the passage of time, i.e., a developer concentrate that has a relatively long "shelf-life", that the present invention is directed.

There has now been discovered a method for stabilizing a developer concentrate containing a quaternary alkanol ammonium hydroxide having the formula:

(I) 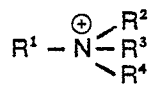 $OH^{\ominus}$

wherein,
$R^1$ is a hydroxyalkyl radical and each of $R^2$, $R^3$ and $R^4$ is independently a hydrocarbyl radical or a hydroxyalkyl radical. Specifically, it has been found that the adverse effects resulting from the decomposition of quaternary alkanol ammonium hydroxide developing agents in developer concentrates can be prevented, or at least substantially reduced, by incorporating in the composition a stabilizing concentration of a sulphite. Thus, the developer concentrates stabilized by the method of this invention have excellent shelf-life characteristics, so that they can be stored for extended periods sometimes a year or more of time without undergoing substantial changes in their performance of the developers formed therefrom.

Preferred quaternary alkanol ammonium hydroxide developing agents which can be used in the developing compositions of this invention are those represented by the formula (I) wherein: $R^1$ is a hydroxyalkyl radical containing 2 to 8 carbon atoms, and each of $R^2$, $R^3$ and $R^4$ is independently selected from hydrocarbyl radicals containing 1 to 10 carbon atoms and hydroxyalkyl radicals containing 2 to 8 carbon atoms.

The quaternary alkanol ammonium hydroxide developing agents which are advantageously used in the developing composition of this invention include:

(a) tetraalkanolammonium hydroxides such as tetraethanolammonium hydroxide,

(b) monoalkyltrialkanolammonium hydroxides such as methyltriethanolammonium hydroxide,

(c) dialkyldialkanolammonium hydroxides

such as dimethyldiethanolammonium hydroxide,

(d) trialkylmonoalkanolammonium hydroxides such as trimethylethanolammonium hydroxide,

(e) monoalkylmono(aralkyl or alkaryl)-dialkanolammonium hydroxides such as benzylmethyldiethanolammonium hydroxide,

(f) dialkylmono(aralkyl or alkaryl)mono-alkanolammonium hdroxides such as benzyl-dimethylethanolammonium hydroxide and

(g) monoaryltrialkanolammonium hydroxides such as benzyltriethanolammonium hydroxide.

Preferred quaternary alkanol ammonium hydroxide developing agents are compounds of the formula (I),

wherein:

$R^1$ is a hydroxyalkyl radical of 2 to 8 carbon atoms,

$R^2$ is a hydrocarbyl radical of 1 to 10 carbon atoms,

$R^3$ is a hydroxyalkyl radical of 2 to 8 carbon atoms or a hydrocarbyl radical of 1 to 10 carbon atoms and

$R^4$ is a hydroxyalkyl radical of 2 to 8 carbon atoms or a hydrocarbyl radical of 1 to 10 carbon atoms.

Especially preferred for the purposes of this invention are the quaternary alkanol ammonium hydroxide developing agents of the formula (I), wherein :

$R^1$ is a hydroxyalkyl radical of 2 to 4 carbon atoms,

$R^2$ is an alkyl radical of 1 to 4 carbon atoms,

$R^3$ is a hydroxyalkyl radical of 2 to 4 carbon atoms, or an alkyl radical of 1 to 4 carbon atoms, and

$R^4$ is a hydroxyalkyl radical of 2 to 4 carbon atoms or an alkyl radical of 1 to 4 carbon atoms.

The preferred developing agent is methyltriethanol ammonium hydroxide.

The quaternary alkanol ammonium hydroxide compound can be employed in any amount sufficient to act as a developing agent. Preferably, the developing composition employed as a working solution is an aqueous solution containing from 1 to 40 percent by weight, and more preferably 3 to 25 percent by weight, of the quaternary alkanol ammonium hydroxide. The optimum concentration of quaternary alkanol ammonium hydroxide is dependent upon a number of factors, such as the particular compound utilized, the particular light-sensitive material to which the developing composition is applied, and the desired development time. The concentrates have a much higher concentration of quaternary alkanol ammonium hydroxide than is desired in the working solution and then are diluted with water prior to use. This is economically advantageous in that it reduces the amount of water which must be shipped and stored.

The developing compositions of this invention include a stabilizing concentration of a sulphite.

The term "a sulphite", as used herein, is intended to encompass ions such as the sulphite ion ($SO_3^{=}$) or the hydrogen sulphite ion ($HSO_3^-$) as well as salts such as sulphite, bisulphite and metabisulphite salts. The ions can be formed by dissolution of the aforesaid salts or by other techniques such as introduction of sulphur dioxide gas ($SO_2$) or sulphurous acid ($H_2SO_3$) into the developing composition.

Included among the useful sulphites are alkali metal sulphites, alkali metal bisulphites, alkali metal metabisulphites, and sulphites of nitrogen bases such as ammonium sulphite or alkanolamine sulphites, e.g. triethanolamine sulphite.

Examples of preferred sulphites for use in the compositions of this invention include sodium sulphite ($Na_2SO_3$), potassium sulphite ($K_2SO_3$), lithium sulphite ($Li_2SO_3$), ammonium sulphite [$(NH_4)_2SO_3$], sodium bisulphite ($NaHSO_3$), potassium bisulphite ($KHSO_3$), lithium bisulphite ($LiHSO_3$), ammonium bisulphite [$(NH_4)HSO_3$], sodium metabisulphite ($Na_2S_2O_5$), potassium metabisulphite ($K_2S_2O_5$), lithium metabisulphite ($Li_2S_2O_5$) and ammonium metabisulphite [$(NH_4)_2S_2O_5$].

The sulphite can be included in the developing composition in any amount that is effective to stabilize it. The optimum amount will depend on several factors, such as the particular developing agent employed, the concentration of the developing agent in the developing composition, the pH of the developing composition, and so forth. Typically, the sulphite should be included in the developing composition in an amount of from 0.01 to 0.4 moles per mole of developing agent, more usually in an amount of from 0.02 to 0.2 moles per mole, and preferably in an amount of from 0.08 to 0.12 moles per mole. In addition to the quaternary alkanol ammonium hydroxide developing agent and the sulphite, the developing compositions can also contain optional ingredients which serve to modify their performance, such as surfactants or organic solvents.

An important requirement in the commercial utilization of photomechanical imaging processes is the ability to form a fine, highly detailed image pattern. This is particularly critical in the utilization of photoresists in the semiconductor industry, for example, in the manufacture of integrated circuit devices. One of the problems restricting the capability of producing the desired fine image detail is contamination of the surface of the substrate by metal ions, such as sodium or potassium ions, which are present in the developer solution. Contamination with such ions can deteriorate the substrate conductivity and adversely affect important properties of the integrated circuit device such as electrical resistivity. Thus, in a preferred embodiment of the present invention, the developing composition is free, or at least substantially free, of metal ions. In such compositions, the required level of sulphite can be conveniently supplied by using a sulphite of a

nitrogen base such as ammonium sulphite.

U.S. Patent 4,141,733 describes light-sensitive lithographic materials containing quinone diazide layers and their use. The developers provided by this invention can be used for developing such materials.

The invention is further illustrated by the following example of its practice.

Ammonium sulphite was added in the quantities indicated below to samples of an aqueous concentrate containing 46 percent by weight of methyltriethanolammonium hydroxide. The samples, all of which were light-yellow in colour, were stored at 22°C in white polyethylene bottles. After one year of storage, each sample was inspected to determine if the colour had changed from the original light-yellow colour. Also, each sample was analyzed for residual sulphite. After diluting each sample with nine parts of distilled water per part of sample, ultraviolet absorbence measurements were made using the 355 nm line of a Beckman Model 26 Spectrophotometer. The results obtained were as follows:

| Sample No. | Original Sulphite Concentration (Weight %) | Original Colour | Sulfite Concentration After One Year (Weight %) | Colour After One Year | Absorbence at 355 nm |
|---|---|---|---|---|---|
| 1 | 0 | Light Yellow | 0 | Dark Brown | 1.422 |
| 2 | 0.1 | Light Yellow | 0 | Dark Brown | 1.714 |
| 3 | 0.5 | Light Yellow | 0 | Amber | 0.700 |
| 4 | 1.0 | Light Yellow | 0 | Light Amber | 0.361 |
| 5 | 5.0 | Light Yellow | 1.11 | Light Yellow | 0.098 |
| 6 | 10.0 | Light Yellow | 2.26 | Light Yellow | 0.094 |

As the above results indicate, storage of the concentrate to which no sulphite was added resulted in a pronounced colour change, in that the concentrate, which was originally light yellow in colour had changed to a dark brown. The results further show that addition of a sulphite retarded the rate of discolouration and that, when a sufficient amount of sulphite was added, no significant colour change occurred in a period of storage of one year.

While the Applicants are not certain of the mechanism whereby his invention functions, it has been determined by chemical analysis that during storage of a concentrated aqueous solution of methyltriethanolammonium hydroxide, a gradual degradation occurs resulting in the formation of small amounts of acetaldehyde and triethanolamine. These degradation products are believed to react in some manner under the influence of their highly alkaline environment to produce coloured compounds that darken progressively with time. By incorporating a stabilizing concentration of a sulphite in the concentrated solution of methyltriethanolammonium hydroxide, the rate of discolouration is substantially reduced and the original development latitude is substantially preserved.

**Claims**

1. A developer concentrate containing a developing agent of the formula:

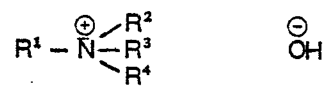

wherein

$R^1$ is hydroxyalkyl; and each of $R^2$, $R^3$ and $R^4$ is hydrocarbyl or hydroxyalkyl; characterised in that said concentrate contains from 0.01 to 0.4 moles of anions selected from $SO_3^{\ominus}$, $HSO_3^{\ominus}$ and $S_2O_5^{\ominus}$ per mole of said developing agent.

2. A concentrate according to claim 1, characterised in that the concentrate is free from metal cations.

3. A concentrate according to claim 1, characterised in that said anions are the anions of an ammonium salt or salts or of other nitrogenous base.

4. A concentrate according to any of claims 1 to 3, characterised in that the concentrate contains from 0.02 to 0.2 moles of said anions per mole of said developing agent.

5. A concentrate according to claim 4, characterised in that the concentrate contains from 0.08 to 0.12 moles of said anions per mole of developing agent.

6. A concentrate according to any of claims 1 to 5, characterised in that said developing agent is methyltriethanol ammonium hydroxide.

7. A concentrate according to claim 1, characterised in that the concentrate contains about 46% by weight of said developing agent.

8. A developer for an exposed lithographic material containing as light-sensitive material

a quinone diazide, characterised in that the developer comprises a developer concentrate according to any of claims 1 to 7 and water.

## Revendications

1. Concentré de révélateur contenant un développateur de formule:

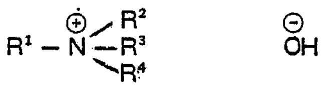

où $R^1$ est un groupe hydroxyalkyle, et chacun des radicaux $R^2$, $R^3$ et $R^4$ est un groupe hydrocarbyle ou hydroxyalkyle, caractérisé en ce que le dit concentré contient de 0,01 à 0,4 mole d'anions choisis parmi $SO_3^{\ominus}$, $HSO_3^{\ominus}$, et $S_2O_5^{\ominus}$ par mole du dit développateur.

2. Concentré conforme à la revendication 1, caractérisé en ce que le dit concentré est exempt de cations métalliques.

3. Concentré conforme à la revendication 1, caractérisé en ce que les dits anions sont des anions d'un sel ou de sels d'ammonium ou d'une autre base azotée.

4. Concentré conforme à l'une quelconque des revendications 1 à 3, caractérisé en ce que le concentré contient de 0,02 à 0,2 mole des dits anions par mole du dit développateur.

5. Concentré conforme à la revendication 4, caractérisé en ce que le concentré contient de 0,08 à 0,12 mole des dits anions par mole de développateur.

6. Concentré conforme à l'une quelconque des revendications 1 à 5, caractérisé en ce que le dit développateur est de l'hydroxyde de méthyl-triéthanol ammonium.

7. Concentré conforme à la revendication 1, caractérisé en ce que le concentré contient environ 46% en masse du dit développateur.

8. Révélateur pour le développement d'un produit lithographique exposé contenant une quinone diazide comme substance photosensible, caractérisé en ce que le révélateur comprend un concentré, conforme à l'une quelconque des revendications 1 à 7, et de l'eau.

## Patentansprüche

1. Entwicklerkonzentrat, welches eine Entwicklersubstanz der Formel

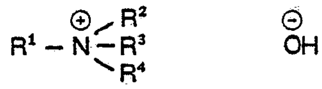

enthält, wobei $R^1$ eine Hydroxyalkylgruppe und $R^2$, $R^3$ und $R^4$ jeweils Hydrocarbyl- oder Hydroxyalkylgruppen sind, dadurch gekennzeichnet, daß das Entwicklerkonzentrat pro Mol Entwicklersubstanz 0,01 bis 0,4 Mol Anionen aus der $SO_3^{\ominus}$, $HSO_3^{\ominus}$ und $S_2O_5^{\ominus}$ umfassenden Gruppe enthält.

2. Konzentrat nach Anspruch 1, dadurch gekennzeichnet, daß das Konzentrat keine Metallkationen aufweist.

3. Konzentrat nach Anspruch 1, dadurch gekennzeichnet, daß die Anionen von einem oder mehreren Ammoniumsalzen oder einer weiteren stickstoffhaltigen Base stammen.

4. Konzentrat nach einem der Ansprüche 1 bis 3, dadurch gekennzeichnet, daß das Konzentrat pro Mol Entwicklersubstanz 0,02 bis 0,2 Mol der genannten Anionen enthält.

5. Konzentrat nach Anspruch 4, dadurch gekennzeichnet, daß das Konzentrat pro Mol Entwicklersubstanz 0,08 bis 0,12 Mol Anionen enthält.

6. Konzentrat nach einem der Ansprüche 1 bis 5, dadurch gekennzeichnet, daß die Entwicklersubstanz aus Methyltriäthanolammoniumhydroxid besteht.

7. Konzentrat nach Anspruch 1, dadurch gekennzeichnet, daß das Konzentrat etwa 46 Gew. % Entwicklersubstanz enthält.

8. Entwickler für ein belichtetes lithographisches Material, welches als lichtempfindliches Material ein Chinondiazid enthält, dadurch gekennzeichnet, daß der Entwickler ein Entwicklerkonzentrat nach einem der Ansprüche 1 bis 7 und Wasser aufweist.